# EUROPÄISCHE PATENTSCHRIFT

(11) **EP 1 843 652 B1**
(45) Veröffentlichungstag und Bekanntmachung des Hinweises auf die Patenterteilung: **28.10.2009**
(21) Anmeldenummer: 07006486.0
(22) Anmeldetag: 29.03.2007
(51) Int. Cl.: H05K 7/20, F04D 25/12, F04D 29/70

(54) **Abdeckvorrichtung für den vorderen Bereich einer Luftdurchtrittseinrichtung sowie Luftdurchtrittseinrichtung**
Cover device for the front section of an air passage device and air passage device
Dispositif de fermeture pour la zone avant d'un dispositif d'aération et dispositif d'aération

(30) Priorität: 05.04.2006 DE 202006005673 U
(43) Veröffentlichungstag der Anmeldung: 10.10.2007
(73) Patentinhaber: Pfannenberg GmbH, 21035 Hamburg (DE)
(72) Erfinder: Pfannenberg, Andreas, 21035 Hamburg (DE)
(74) Vertreter: Richter, Werdermann, Gerbaulet & Hofmann

(56) Entgegenhaltungen:
- DE-A1- 10 038 821
- DE-U1- 20 002 124

## Beschreibung

### Anwendungsgebiet

Die Erfindung betrifft eine Abdeckvorrichtung für den vorderen Bereich einer Luftdurchtrittseinrichtung gemäß dem Oberbegriff des Anspruches 1 sowie eine Luftdurchtrittsvorrichtung.

### Stand der Technik

Eine derartige Abdeckvorrichtung, wie es im DE 200 02 124 U offenbart wird, die mitunter auch als Abdeckgehäuse, als Abdeckplatte, als Deckelplatte oder auch als "Designdeckel" bezeichnet wird, ist im Regelfall dem vorderen Bereich eines Filterlüfters vorgeschaltet. Im Zuge der Tatsache, dass ein derartiger Filterlüfter bei seinem Betrieb (Umgebungs-)Luft durch eine Filtermatte ansaugt, lässt es sich nicht vermeiden, dass die Abdeckvorrichtung auch sich in der (Umgebungs-)Luft befindliche Flüssigkeitspartikel oder Flüssigkeitstropfen - etwa Regenwassertropfen bei Außeneinsätzen des Filterlüfters - ansaugt. Mithin sammeln sich zwangsläufig Flüssigkeit sowie Substanzen von flüssigkeitsähnlicher Konsistenz im Bereich der Abdeckvorrichtung, insbesondere im Bereich zwischen der Abdeckvorrichtung und dem Filterlüfter an.

### Aufgabe, Lösung, Vorteil

Es ist daher Aufgabe der vorliegenden Erfindung, den Designdeckel einer Luftdurchtrittseinrichtung mit Lamellenelementen zu versehen, die ein Eindringen von Wasser oder Staubteilchen in die Filtermatte verhindern oder verringern und die ein Zurückhalten und außenseitiges Ablaufen von Wasser gewährleisten, ohne dass die Luftdurchströmmenge verringert wird.

Diese Aufgabe wird bei einer gattungsgemäßen Abdeckvorrichtung mit den im Anschluss 1 angegebenen Merkmalen gelöst.

Hiernach besteht die Erfindung darin, dass jedes Lamellenelement in seinem oberen Bereich einen entgegen der Lufteinströmung gerichteten Abschnitt mit einer hakenartigen Formgebung aufweist.

Der Abschnitt mit der hakenartigen Formgebung erstreckt sich über die Länge des Lamellenelementes.

Dabei sind die Lamellenelemente derart zueinander angeordnet, dass sich die Lamellenelemente abschnittsweise überdecken, wobei der untere Bereich eines jeden Lamellenelementes auf einer unterhalb des Abschnittes mit der hakenartigen Formgebung verlaufenden waagerechten Ebene E liegt oder auf einer oberhalb des Abschnittes mit der hakenartigen Formgebung verlaufenden waagerechten Ebene E1 oder in einem Bereich zwischen den beiden Ebenen E und E1 liegt.

Weitere vorteilhafte Ausgestaltungen und zweckmäßige Weiterbildungen der Erfindung sind in den Unteransprüchen gekennzeichnet.

So besteht die Abdeckvorrichtung nach einer weiteren Ausführungsform aus einem rahmenartigen Gehäuse zur Aufnahme der Filtermatte und einem in dem Gehäuse fest, lösbar oder verschwenkbar gehaltenen und die Filtermatte abdeckenden Designdeckel, der mindestens zwei laterale, sich randseitig in einer Längsrichtung erstreckende, vorzugsweise wangenförmig ausgebildete Halteelemente umfasst, zwischen denen mehrere Lamellenelemente angeordnet sind, die in einem Abstand voneinander bei gleichzeitiger abschnittsweiser Überdeckung angeordnet und derart schrägt gestellt angeordnet sind, dass die jeweils vorderen und außenliegenden Lamellenkanten gegenüber den rückwärtigen Lamellenkanten tiefer gelegen sind, wobei die oberen, rückwärtigen Lamellenkanten der eine vorzugsweise bogenförmige Ausgestaltung aufweisenden Lamellenelemente widerhakenartig ausgebildete Formgebung aufweisen.

Die einzelnen Lamellenelemente sind zueinander derart angeordnet, dass eine hohe optische Überdeckung und ein Sichtschutz auf die Filtermatte bei optimaler Luftdurchlässigkeit erhalten wird.

Zur Erzielung einer geräuschoptimierten Lamellenform weist jedes Lamellenelement abgerundete, vordere Lamellenkanten auf.

Des weiteren sieht die Erfindung vor, dass die die widerhakenartige Formgebung aufweisende rückwärtige Lamellenrandkante eines jeden Lamellenelementes eine Querschnittsform aufweist, die in etwa der Form eines Halbkreises mit einem vorderseitig auskragenden Abschnitt entspricht.

Eine weitere Ausgestaltung der Erfindung besteht darin, dass der Bereich der vorderen Lamellenkante eines jeden Lamellenelementes eine Materialverstärkung aufweist, so dass der tiefer gelegene vordere Randkantenbereich eines jeden Lamellenelementes gegenüber dem rückwärtigen und höher gelegenen Randkantenbereich eine größere Dicke aufweist.

Durch die erfindungsgemäße Ausgestaltung der Abdeckvorrichtung wird, insbesondere durch die Formgebung der einzelnen Lamellenelemente erreicht, dass vom Ventilator des Filterlüfters angesogener Staub und Wasser von den Lamellenelementen zumindest bzw. teilweise zurückgehalten werden. Auf die Abdeckvorrichtung auftreffendes Wasser läuft zum größten Teil nach außen ab, so dass die Filtermatte nur geringfügig bzw. wenig vom Wasser benetzt wird.

Des weiteren betrifft die Erfindung nach Anspruch 11 eine Luftdurchtrittseinrichtung, wie Filterlüfter oder Austrittsfilter, für den Einbau in eine Durchbrechung in einer Wand eines Gehäuses, insbesondere eines Gehäuses mit Abwärme erzeugenden Bauteilen, eines Elektronikschrankes, eines Schaltschrankes, eines Gehäusesystems oder eines Computersystems, mit einer Abdeckvorrichtung, insbesondere zum Abdecken des vorderen Bereiches der Luftdurchtrittseinrichtung, und für die Filtermatte der Luftdurchtrittseinrichtung, wobei die Abdeckvorrichtung einen die Filtermatte abdeckenden Designdeckel mit einer Anzahl schräg gestellter Lamellenelemente umfasst, wobei jedes Lamellenelement in seinem oberen Bereich einen entgegen der Lufteinströmung gerichteten Abschnitt mit einer hakenartigen Formgebung aufweist.

Auch bei dieser Ausführungsform erstreckt sich der Abschnitt mit der hakenartigen Formgebung über die Länge des Lamellenelementes.

Die Lamellenelemente sind derart zueinander angeordnet, dass sich die Lamellenelemente abschnittsweise überdecken, wobei der untere Bereich eines jeden Lamellenelementes auf einer unterhalb des Abschnittes mit der hakenartigen Formgebung verlaufenden waagerechten Ebene E liegt oder auf einer oberhalb des Abschnittes mit der hakenartigen Formgebung verlaufenden waagerechten Ebene E1 oder in einem Bereich zwischen den beiden Ebenen E und E1 liegt.

Weiterbildungen der Luftdurchtrittseinrichtung mit der Abdeckvorrichtung sind Gegenstand der Ansprüche 12 bis 20.

### Kurzbeschreibung der Zeichnung

In der Zeichnung sind Ausführungsbeispiele der Erfindung dargestellt und zwar zeigt:
- Fig. 1: eine Luftdurchtrittseinrichtung in Form eines Filterlüfters mit der erfindungsgemäßen als Designdeckel ausgebildeten Abdeckvorrichtung mit in dem Designdeckel ausgebildeten Lamellenelementen in perspektivischer Explosionsdarstellung,
- Fig. 2: eine schaubildliche Darstellung des Grundgehäuses der Luftdurchtrittseinrichtung mit aufgeklapptem Designdeckel und mit zwischen dem Grundgehäuse und dem Designdeckel liegender Filtermatte,
- Fig. 3: einen senkrechten Schnitt durch die Luftdurchtrittsvorrichtung,
- Fig. 4: in einer Vorderansicht den Designdeckel mit Lamellenelementen,
- Fig. 5: in einer schaubildlichen Rückansicht den Designdeckel,
- Fig. 6: einen Abschnitt des Designdeckels in einer vergrößerten, schaubildlichen Darstellung,
- Fig. 7: einen Abschnitt des Designdeckels in einer vergrößerten, schaubildlichen Darstellung,
- Fig. 8: einen Abschnitt des Designdeckels mit Lamellenelementen mit einendseitiger hakenartiger Formgebung in einem vergrößerten Längsschnitt,
- Fig. 8A: einen Abschnitt des Designdeckels mit Lamellenelementen in einer weiteren Ausführungsform in einem vergrößerten Längsschnitt und
- Fig. 9: schematisch die Anordnung von zwei Lamellenelementen mit aerodynamisch ausgebildeten vorderen Endbereichen.

### Detaillierte Beschreibung der Erfindung und bester Weg zur Ausführung der Erfindung

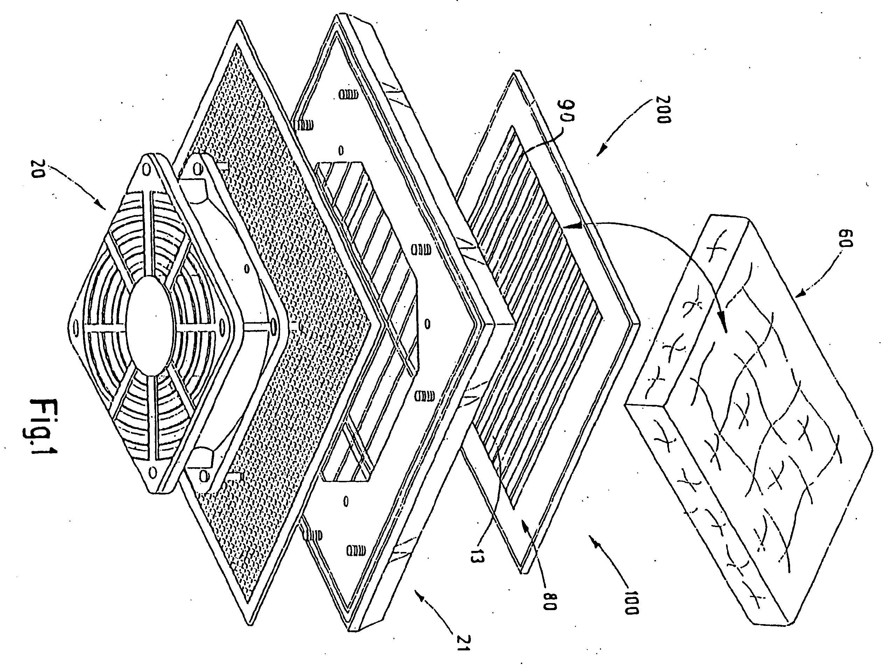

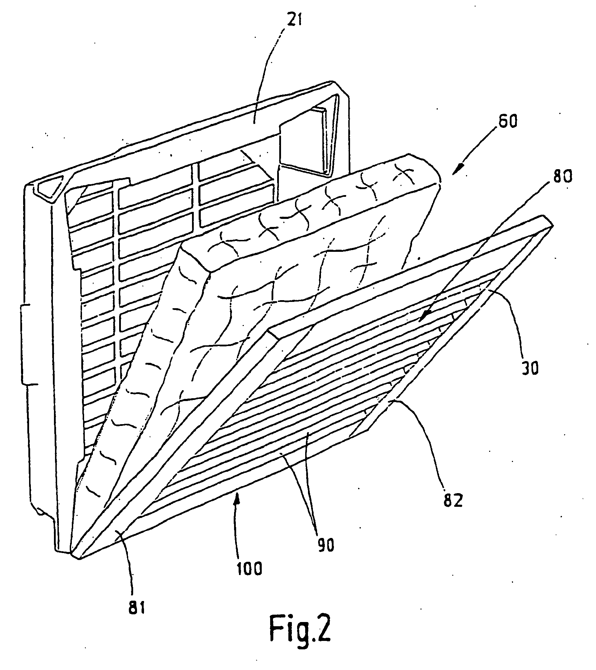

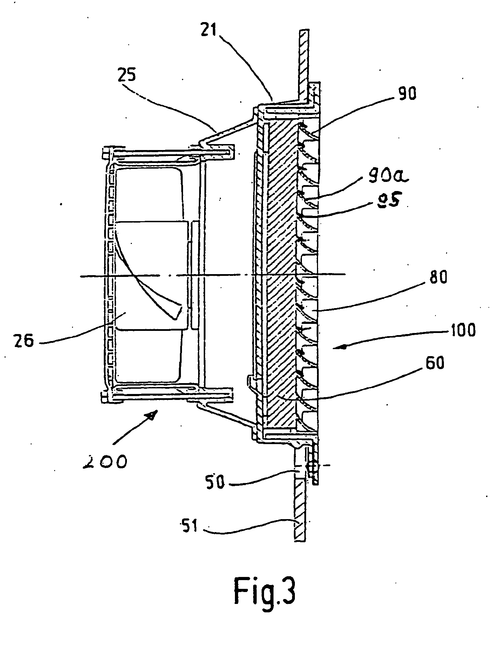

Die in Fig. 1 bis 3 dargestellte Luftdurchtrittsvorrichtung 200 ist in Verbindung mit einem Gebläse bzw. Ventilator als Filterlüfter und ohne Gebläse 20 als Austrittsfilter einsetzbar. Eingesetzt wird die Luftdurchtrittsvorrichtung 200 bei Gehäusen von abwärmeerzeugenden Bauteilen, wie Schaltschränke, Elektronikschränke, Computersystem o. dgl., wobei die Luftdurchtrittsvorrichtung 200 in Montagedurchbrechungen 50 in einer Wand 59 eines derartigen Gehäuses eingebaut wird (Fig. 3).

Die wesentlichen Bauteile der Luftdurchtrittsvorrichtung 200 sind ein Lüftergitter, das als Designdeckel 80 mit Lüftungsschlitzen ausgebildet ist und die erfindungsgemäße Abdeckvorrichtung 100 bildet, ein Grundgehäuse 21, ein Gebläseträger 25 für das Gebläse 26 und das Gebläse 26, wenn die Luftdurchtrittsvorrichtung 200 als Filterlüfter eingesetzt wird (Fig. 1 bis 3).

Die Abdeckvorrichtung 100, die das Lüftergitter bildet, ist als Designdeckel 80 ausgebildet und besteht aus einem rahmenartigen Gehäuse 30 mit Lamellenelementen 90, wobei zwischen den sich abschnittsweise überlappenden Lamellenelementen 90 Lüftungsschlitze ausgebildet sind. Die Filtermatte 60 kann an der Innenwandfläche des Designdeckels 80 gehalten sein (Fig. 3) oder sie wird in das Grundgehäuse eingelegt. Die Lamellenelemente 90 sind in Halteelementen 81, 82 gehalten, die den Rahmen des Designdeckels 80 bilden.

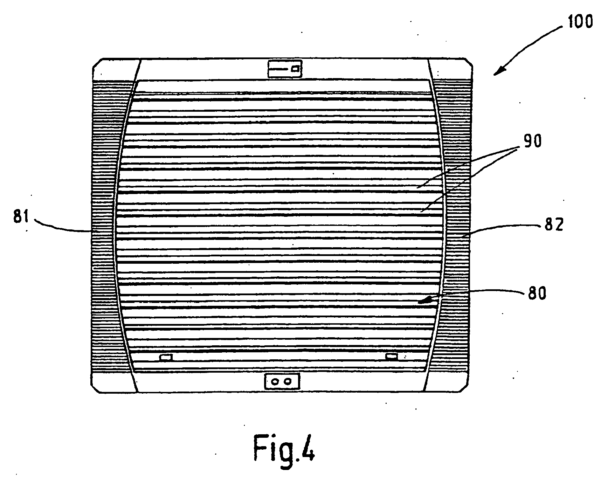

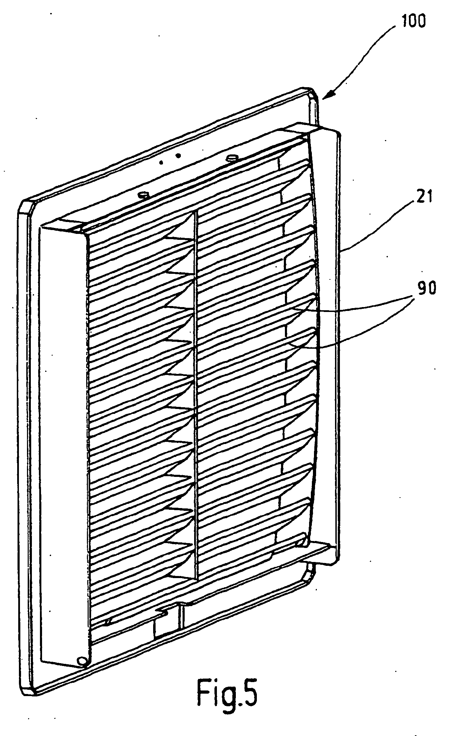

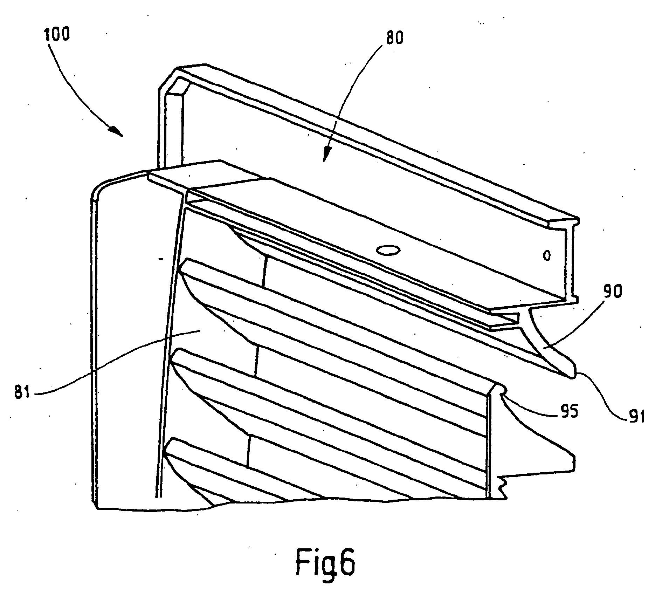

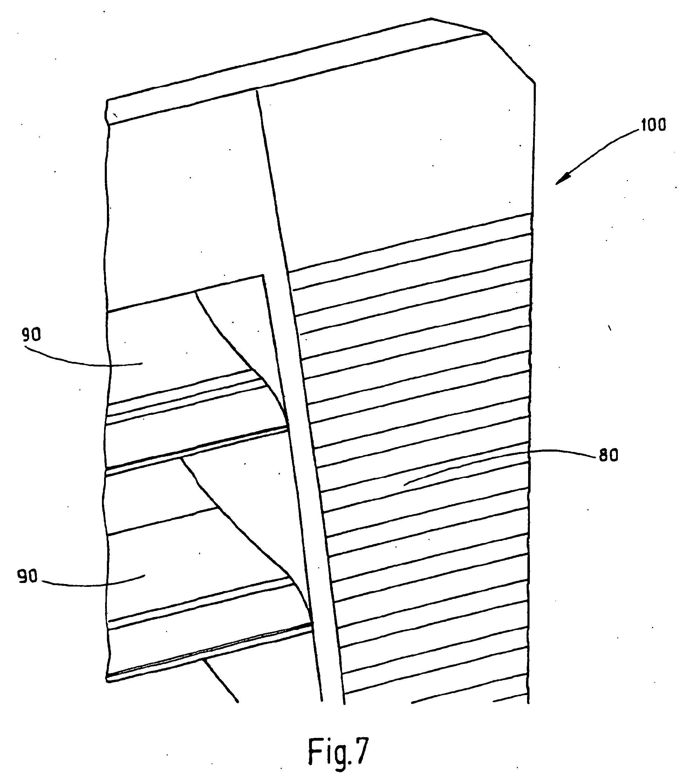

Die Abdeckvorrichtung 100 besteht aus einem rahmenartigen Gehäuse 30 zur Aufnahme der Filtermatte 60 und einem in dem Gehäuse 30 fest, lösbar oder verschwenkbar gehaltenen und die Filtermatte 60 abdeckenden Designdeckel 80. Dieser Designdeckel 80 umfasst mindestens zwei laterale, sich randseitig in einer Längsrichtung L erstreckende, vorzugsweise wangenförmig ausgebildeten Halteelementen 81, 82, zwischen denen die Lamellenelemente 90 angeordnet sind (Fig. 4 und 5). Die Lamellenelemente 90 sind bei gleichzeitiger abschnittsweiser Überdeckung in einem Abstand voneinander angeordnet und derart schräg gestellt, das die jeweils vorderen und außenliegenden Lamellenkanten 91 gegenüber den rückwärtigen Lamellenkanten 92 tiefer gelegen sind. Die oberen rückwärtigen Lamellenkanten 92 der eine bogenförmige Ausgestaltung aufweisenden Lamellenelemente 90 weisen widerhakenartig bzw. hakenartig ausgebildete Formgebungen 95 auf (Fig. 6 bis 8, 8A und 9).

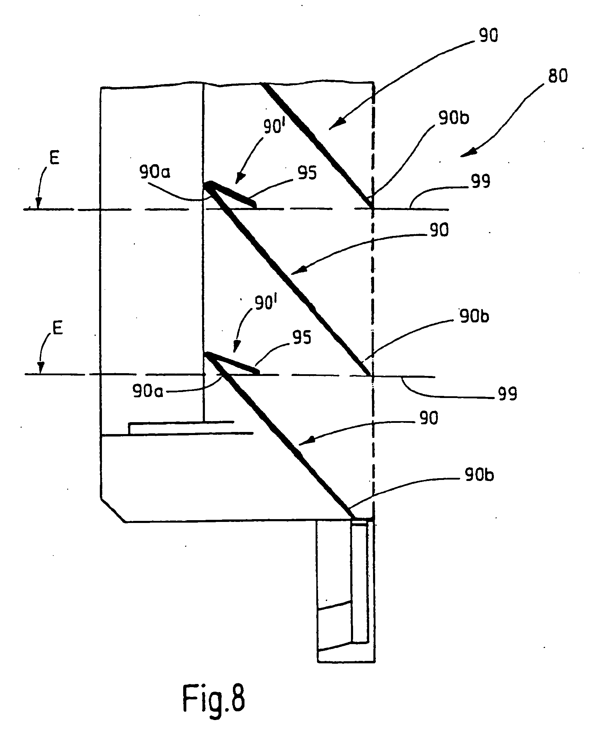

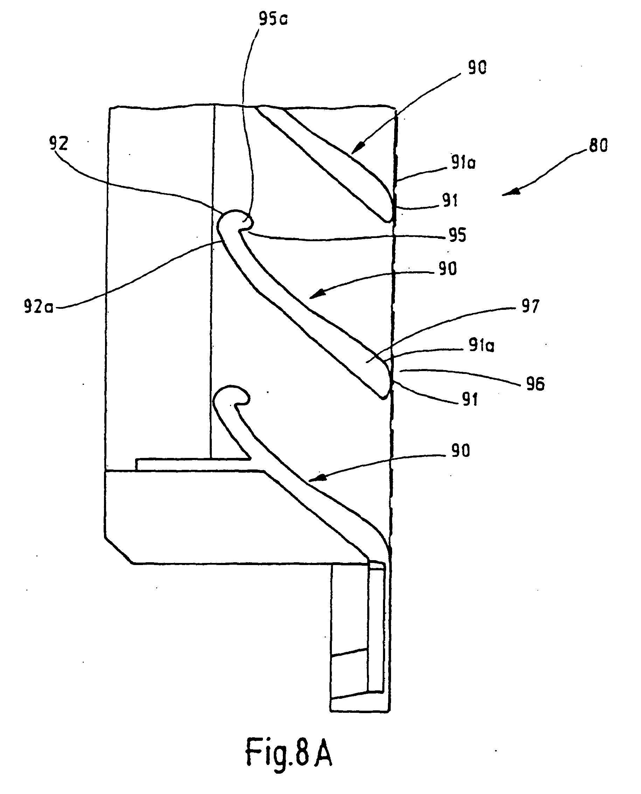

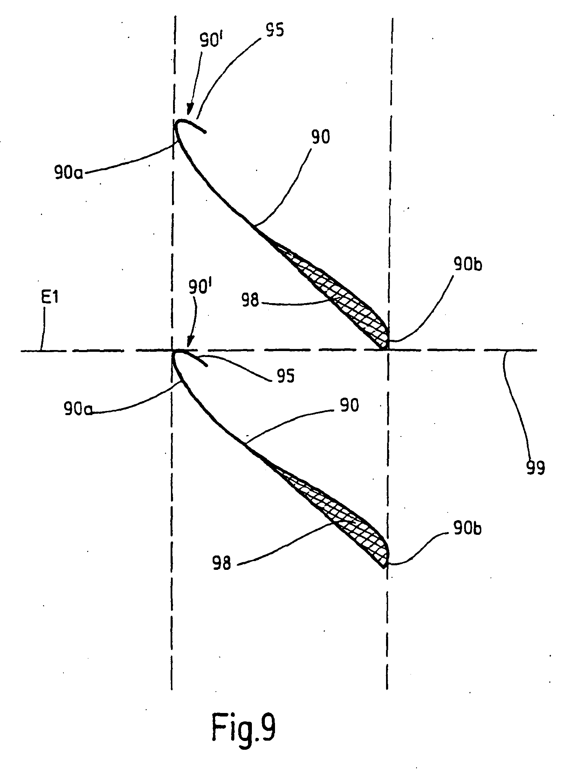

Wie die Fig. 8, 8A und 9 zeigen, weist jedes Lamellenelement 90 in seinem oberen Bereich 90a einen entgegen der Lufteinströmung gerichteten Abschnitt 90' mit einer hakenartigen Formgebung 95 auf. Der Abschnitt 90' mit der hakenartigen Formgebung 95 erstreckt sich dabei über die Länge des Lamellenelementes 90. Dabei sind die Lamellenelemente 90 derart zueinander angeordnet, dass sich die Lamellenelemente abschnittsweise überdecken, wobei der jeweils untere Bereich 90b eines jeden Lamellenelementes auf einer unterhalb des Abschnittes 90' mit der hakenartigen Formgebung verlaufenden waagerechten Ebene E liegt oder auf einer oberhalb des Abschnittes 90' mit-der hakenartigen Formgebung 95 verlaufenden waagerechten Ebene E1 oder in einem Bereich zwischen den beiden Ebenen E und E1 liegt.

Die einzelnen Lamellenelemente 90 sind des weiteren derart zueinander angeordnet, dass auch eine hohe optische Überdeckung und ein Sichtschutz auf die Filtermatte 60 bei optimaler Luftdurchlässigkeit erhalten wird.

Zur Erzielung einer geräuschoptimierten Lamellenform weist jedes Lamellenelement 90 abgerundete fordere Längsrandkanten 96 auf.

Die die widerhakenartige Formgebung 95 aufweisende rückwärtige Lamellenkante 92 eines jeden Lamellenelementes 90 weist eine Querschnittsform auf, die in etwa der Form eines Halbkreises mit einem vorderseitig auskragenden Abschnitt 95a entspricht. Der Bereich der vorderen Lamellenkante 91 eines jeden Lamellenelementes 90 weist eine Materialverstärkung 97 auf, so dass der tiefer gelegene vordere Randkantenabschnitt 91 a eines jeden Lamellenelementes gegenüber des rückwärtigen und höher gelegenen Randkantenbereichs 92a eine größere Dicke aufweist. Aufgrund dieser Ausgestaltung weist jedes Lamellenelement 90 eine bogenförmige verlaufende Oberfläche auf, die im oberen Bereich eines jeden Lamellenelementes in die widerhakenartige Lamellenausgestaltung ausläuft. Auf diese Weise wird vom Ventilator der Luftdurchtrittsvorrichtung 200 angesogenes Wasser durch die widerhakenartige Formgebung 95 der einzelnen Lamellenelemente 90 zurückgehalten und tropft somit nach unten ab bzw. einzelne sich ansammelnde Tröpfchen wachsen und laufen anschließend nach vorn ab.

Der Designdeckel 80 mit seinen Lamellenelementen 90 besteht bevorzugterweise aus einem Kunststoff oder einem anderen geeigneten Material.

In Fig. 9 sind zwei übereinanderliegende Lamellenelemente 90 dargestellt, die zueinander derart angeordnet sind, dass sich eine Überdeckung ergibt. Die Lamellenelemente 90 sind in etwa S-förmig verlaufend ausgebildet, wobei im vorderen abgebogenen Bereich 90b eines jeden Lamellenelementes eine Materialauffüllung 98 vorgesehen ist, wodurch ein aerodynamischer Bereich geschaffen wird, denn ohne diese Maßnahme es zu Luftmengenverlusten kommen kann. Der obere Bereich 90a eines jeden Lamellenelementes 90 weist die hakenartige Formgebung 95 auf. Der jeweilige Überdeckungsbereich zweier Lamellenelemente 90 ist bei 99 angedeutet.

Jedes Lamellenelement 90 kann einteilig (Fig. 4) oder zweiteilig (Fig. 5) ausgebildet sein oder aus mehreren gleichlangen oder ungleichlangen Abschnitten bestehen.

### Bezugszeichenliste

- 200: Luftdurchtrittsvorrichtung
- 100: Abdeckvorrichtung

- 20: Gebläse
- 21: Grundgehäuse
- 25: Gebläseträger
- 26: Gebläse

- 30: rahmenartiges Gehäuse

- 50: Montagedurchbrechung
- 51: Wand

- 60: Filtermatte

- 80: Designdeckel
- 81: Halteelemente
- 82: Halteelemente

- 90: Lamellenelemente
- 90a: obere Bereich
- 90b: vordere Bereich
- 91: vordere Lamellenkanten
- 91 a: vorderer Randkantenbereich
- 92: rückwärtige Lamellenkanten
- 92a: rückwärtiger Randkantenbereich
- 95: widerhakenartige Formgebung
- 95a: auskragender Abschnitt
- 96: abgerundete vordere Längsrandkanten
- 97: Materialverstärkung
- 98: Materialauffüllung
- 99: Überdeckungsbereich

## Patentansprüche

1. Abdeckvorrichtung (100) zum Abdecken des vorderen Bereiches einer Luftdurchtrittseinrichtung (200), wie Filterlüfter oder Austrittsfilter, für den Einbau in eine Durchbrechung in einer Wand eines Gehäuses, insbesondere eines Gehäuses mit Abwärme erzeugenden Bauteilen, eines Elektronikschrankes, eines Schaltschrankes, eines Gehäusesystems oder eines Computersystems, und für die Filtermatte (60) der Luftdurchtrittseinrichtung, wobei die Abdeckvorrichtung einen die Filtermatte (60) abdeckenden Designdeckel (80) mit einer Anzahl schräg gestellter Lamellenelemente (90) umfasst,
**dadurch gekennzeichnet,**
**dass** jedes Lamellenelement (90) in seinem oberen Bereich (90a) einen entgegen der Lufteinströmung gerichteten Abschnitt (90') mit einer hakenartigen Formgebung (95) aufweist.

2. Abdeckvorrichtung nach Anspruch 1,
**dadurch gekennzeichnet,**
**dass** sich der Abschnitt (90') mit der hakenartigen Formgebung (95) über die Länge des Lamellenelementes (90) erstreckt.

3. Abdeckvorrichtung nach einem der Ansprüche 1 oder 2,
**dadurch gekennzeichnet,**
**dass** die Lamellenelemente (90) derart zueinander angeordnet sind, dass sich die Lamellenelemente abschnittsweise überdecken, wobei der untere Bereich (90b) eines jeden Lamellenelementes auf einer unterhalb des Abschnittes (90') mit der hakenartigen Formgebung (95) verlaufenden waagerechten Ebene (E) liegt oder auf einer oberhalb des Abschnittes (90') mit der hakenartigen Formgebung (95) verlaufenden waagerechten Ebene (E1) oder in einem Bereich zwischen den beiden Ebenen (E, E1) liegt.

4. Abdeckvorrichtung nach einem der Ansprüche 1 bis 3,
**dadurch gekennzeichnet,**
**dass** die Abdeckvorrichtung (100) aus einem rahmenartigen Gehäuse (30) zur Aufnahme der Filtermatte (60) und einem in dem Gehäuse (30) fest, lösbar oder verschwenkbar gehaltenen und die Filtermatte (60) abdeckenden Designdeckel (80) besteht, der mindestens zwei laterale, sich randseitig in einer Längsrichtung (L) erstreckende, vorzugsweise wangenförmig ausgebildete Halteelemente (81, 82) umfasst, zwischen denen mehrere Lamellenelemente (90) angeordnet sind, die in einem Abstand voneinander und bei gleichzeitiger abschnittsweiser Überdeckung angeordnet und derart schräg gestellt angeordnet sind, dass die jeweils vorderen und außenliegenden Lamellenkanten (91) gegenüber den rückwärtigen Lamellenkanten (92) tiefergelegen sind, wobei die oberen, rückwärtigen Lamellenkanten (92) der eine bogenförmige Ausgestaltung aufweisenden Lamellenelemente (90) eine widerhakenartig ausgebildete Formgebung (95) aufweisen.

5. Abdeckvorrichtung nach einem der Ansprüche 1 bis 4,
**dadurch gekennzeichnet,**
**dass** die einzelnen Lamellenelemente (90) zueinander derart angeordnet sind, dass eine hohe optische Überdeckung und ein Sichtschutz auf die Filtermatte (60) bei optimaler Luftdurchlässigkeit erhalten wird.

6. Abdeckvorrichtung nach einem der Ansprüche 1 bis 5,
**dadurch gekennzeichnet,**
**dass** das eine etwa S-förmige Ausgestaltung aufweisende Lamellenelement (90) in seinem unteren bogenförmigen Bereich und unterhalb eine Materialauffüllung (98) aufweist.

7. Abdeckvorrichtung nach einem der Ansprüche 1 bis 6,
**dadurch gekennzeichnet,**
**dass** die die hakenartige Formgebung (95) aufweisende rückwärtige Lamellenkante (92) eines jeden Lamellenelementes (90) eine Querschnittsform aufweist, die in etwa der Form eines Halbkreises mit einem vorderseitig auskragenden Abschnitt (95a) entspricht.

8. Abdeckvorrichtung nach einem der Ansprüche 1 bis 7,
**dadurch gekennzeichnet,**
**dass** der Bereich der vorderen Lamellenkante (91) eines jeden Lamellenelementes (90) eine Materialverstärkung (97) aufweist, so dass der tiefer gelegene vordere Randkantenbereich (91a) eines jeden Lamellenelementes gegenüber des rückwärtigen und höher gelegenen Randkantenbereiches (92a) eine größere Dicke aufweist.

9. Abdeckvorrichtung nach einem der Ansprüche 1 bis 8,
**dadurch gekennzeichnet,**
**dass** der Designdeckel (80) mit seinen Lamellenelementen (90) aus einem Kunststoff oder einem anderen geeigneten Material besteht, wobei die Lamellenelemente ein- oder mehrteilig ausgebildet sind.

10. Abdeckvorrichtung nach einem der Ansprüche 1 bis 9,
**dadurch gekennzeichnet,**
**dass** zur Erzielung einer geräuschoptimierten Lamellenform jedes Lamellenelement (90) abgerundete, vordere Längsrandkanten (96) aufweist.

11. Luftdurchtrittseinrichtung (200) wie Filterlüfter oder Austrittsfilter, für den Einbau in eine Durchbrechung in einer Wand eines Gehäuses, insbesondere eines Gehäuses mit Abwärme erzeugenden Bauteilen, eines Elektronikschrankes, eines Schaltschrankes, eines Gehäusesystems oder eines Computersystems, und für die Filtermatte (60) der Luftdurchtrittseinrichtung, die eine Abdeckvorrichtung (100) zum Abdecken des vorderen Bereiches umfasst, die einen die Filtermatte (60) abdeckenden Designdeckel (80) mit einer Anzahl schräg gestellter Lamellenelemente (90) aufweist, wobei jedes Lamellenelement (90) in seinem oberen Bereich (90a) einen entgegen der Lufteinströmung gerichteten Abschnitt (90') mit einer hakenartigen Formgebung (95) aufweist.

12. Luftdurchtrittseinrichtung nach Anspruch 11,
**dadurch gekennzeichnet,**
**dass** sich der Abschnitt (90') mit der hakenartigen Formgebung (95) über die Länge des Lamellenelementes (90) erstreckt.

13. Luftdurchtrittseinrichtung nach einem der Ansprüche 11 oder 12,
**dadurch gekennzeichnet,**
**dass** die Lamellenelemente (90) der Abdeckvorrichtung (100) derart zueinander angeordnet sind, dass sich die Lamellenelemente abschnittsweise überdecken, wobei der untere Bereich (90b) eines jeden Lamellenelementes auf einer unterhalb des Abschnittes (90') mit der hakenartigen Formgebung (95) verlaufenden waagerechten Ebene (E) liegt oder auf einer oberhalb des Abschnittes (90') mit der hakenartigen Formgebung (95) verlaufenden waagerechten Ebene (E1) oder in einem Bereich zwischen den beiden Ebenen (E, E1) liegt.

14. Luftdurchtrittseinrichtung nach einem der Ansprüche 11 bis 13,
**dadurch gekennzeichnet,**
**dass** die Abdeckvorrichtung (100) aus einem rahmenartigen Gehäuse (30) zur Aufnahme der Filtermatte (60) und einem in dem Gehäuse (30) fest, lösbar oder verschwenkbar gehaltenen und die Filtermatte (60) abdeckenden Designdeckel (80) besteht, der mindestens
zwei laterale, sich randseitig in einer Längsrichtung (L) erstreckende, vorzugsweise wangenförmig ausgebildete Halteelemente (81, 82) umfasst, zwischen denen mehrere Lamellenelemente (90) angeordnet sind, die in einem Abstand voneinander und bei gleichzeitiger abschnittsweiser Überdeckung angeordnet und derart schräg gestellt angeordnet sind, dass die jeweils vorderen und außenliegenden Lamellenkanten (91) gegenüber den rückwärtigen Lamellenkanten (92) tiefergelegen sind, wobei die oberen, rückwärtigen Lamellenkanten (92) der eine bogenförmige Ausgestaltung aufweisenden Lamellenelemente (90) eine widerhakenartig ausgebildete Formgebung (95) aufweisen.

15. Luftdurchtrittseinrichtung nach einem der Ansprüche 11 bis 14,
**dadurch gekennzeichnet,**
**dass** die einzelnen Lamellenelemente (90) zueinander derart angeordnet sind, dass eine hohe optische Überdeckung und ein Sichtschutz auf die Filtermatte (60) bei optimaler Luftdurchlässigkeit erhalten wird.

16. Luftdurchtrittseinrichtung nach einem der Ansprüche 11 bis 15,
**dadurch gekennzeichnet,**
**dass** das eine etwa S-förmige Ausgestaltung aufweisende Lamellenelement (90) in seinem unteren bogenförmigen Bereich und unterhalb eine Materialauffüllung (98) aufweist.

17. Luftdurchtrittseinrichtung nach einem der Ansprüche 11 bis 16,
**dadurch gekennzeichnet,**
**dass** die die hakenartige Formgebung (95) aufweisende rückwärtige Lamellenkante (92) eines jeden Lamellenelementes (90) eine Querschnittsform aufweist, die in etwa der Form eines Halbkreises mit einem vorderseitig auskragenden Abschnitt (95a) entspricht.

18. Luftdurchtrittseinrichtung nach einem der Ansprüche 11 bis 17,
**dadurch gekennzeichnet,**
**dass** der Bereich der vorderen Lamellenkante (91) eines jeden Lamellenelementes (90) eine Materialverstärkung (97) aufweist, so dass der tiefer gelegene vordere Randkantenbereich (91a) eines jeden Lamellenelementes gegenüber des rückwärtigen und höher gelegenen Randkantenbereiches (92a) eine größere Dicke aufweist.

19. Luftdurchtrittseinrichtung nach einem der Ansprüche 11 bis 18,
**dadurch gekennzeichnet,**
**dass** der Designdeckel (80) mit seinen Lamellenelementen (90) aus einem Kunststoff oder einem anderen geeigneten Material besteht, wobei die Lamellenelemente ein- oder mehrteilig ausgebildet sind.

20. Luftdurchtrittseinrichtung nach einem der Ansprüche 11 bis 19,
**dadurch gekennzeichnet,**
**dass** zur Erzielung einer geräuschoptimierten Lamellenform jedes Lamellenelement (90) abgerundete, vordere Längsrandkanten (96) aufweist.

## Claims

1. A cover device (100) to cover the front section of an air passage device (200), such as a filter fan or outlet filter, for installation in an opening in a wall of a housing, in particular a housing with components which generate waste heat, of an electronics cabinet, a switch cabinet, an enclosure system or a computer system, and for the filter pad (60) of the air passage device, wherein the cover device comprises a design cover (80) which covers the filter pad (60) with a number of lamellar elements (90) which stand obliquely,
**characterized in that,**
each lamellar element (90) has in its upper section (90a) a segment (90') with a hook-like shape (95) which is directed towards the inflow of air.

2. A cover device according to claim 1,
**characterized in that,**
the segment (90') with the hook-like shape (95) extends over the length of the lamellar element (90).

3. A cover device according to any one of claims 1 or 2,
**characterized in that,**
the lamellar elements (90) are arranged with respect to one another in such a way that the lamellar elements overlap in segments, wherein the lower section (90b) of each lamellar element lies on a horizontal plane (E) running below the segment (90') with the hook-like shape (95) or on a horizontal plane (E1) running above the segment (90') with the hook-like shape (95) or in an area between the two planes (E, E1).

4. A cover device according to any one of claims 1 through 3,
**characterized in that,**
the cover device (100) consists of a frame-like housing (30) for accommodating the filter pad (60) and a design cover (80) which is held in the housing (30) firmly, detachably or in a manner allowing it to swivel and covers the filter pad (60) and which comprises at least two lateral supporting elements (81, 82), which are preferably flange-shaped and extend in a longitudinal direction (L) on the edge side and between which there are arranged multiple lamellar elements (90) which are arranged at a distance from one another and in such a way that, at the same time, they overlap in segments and are set obliquely such that the lamellar edges (91) lying at the front and outwardly in each case are set lower down than the rear lamellar edges (92), wherein the upper, rear lamellar edges (92) of those lamellar elements (90) which have a bow-shaped design have a barbed-hook-like shape (95).

5. A cover device according to any one of claims 1 through 4,
**characterized in that,**
the individual lamellar elements (90) are arranged with respect to one another in such a way that a high visual overlap and a visual cover for the filter pad (60) are maintained with optimal air transmissibility.

6. A cover device according to any one of claims 1 through 5,
**characterized in that,**
the lamellar element (90) which has an approximately S-shaped design has a material filling (98) in its lower bow-shaped section and underneath that.

7. A cover device according to any one of claims 1 through 6,
**characterized in that,**
the rear lamellar edge (92) which has the hook-like shape (95) of each lamellar element (90) has a cross-sectional shape which corresponds approximately to the shape of a semicircle with a segment (95a) protruding on the front side.

8. A cover device according to any one of claims 1 through 7,
**characterized in that,**
the area of the front lamellar edge (91) of each lamellar element (90) has a material reinforcement (97), so that the lower-lying area of the front perimeter edge (91 a) of each lamellar element comprises a greater thickness relative to the rear and higher-lying perimeter edge area (92a).

9. A cover device according to any one of claims 1 through 8,
**characterized in that,**
the design cover (80) with its lamellar elements (90) consists of a plastic or another suitable material, wherein the lamellar elements are formed from one or multiple parts.

10. A cover device according to any one of claims 1 through 9,
**characterized in that,**
each lamellar element (90) has rounded front longitudinal perimeter edges (96) to achieve a sound-optimized lamellar shape.

11. An air passage device (200), such as a filter fan or an outlet filter, for installation in an opening in a wall of a housing, in particular a housing with components which generate waste heat, of an electronics cabinet, a switch cabinet, an enclosure system or a computer system, and for the filter pad (60) of the air passage device, which, to cover the front section, comprises a cover device (100) which has a design cover (80) which covers the filter pad (60) with a number of lamellar elements (90) which stand obliquely, wherein each lamellar element (90) has in its upper section (90a) a segment (90') with a hook-like shape (95) which is directed towards the inflow of air.

12. An air passage device according to claim 11,
**characterized in that,**
the segment (90') with the hook-like shape (95) extends over the length of the lamellar element (90).

13. An air passage device according to any one of claims 11 or 12,
**characterized in that,**
the lamellar elements (90) of the cover device (100) are arranged with respect to one another in such a way that the lamellar elements overlap in segments, wherein the lower section (90b) of each lamellar element lies on a horizontal plane (E) running below the segment (90') with the hook-like shape (95) or on a horizontal plane (E1) running above the segment (90') with the hook-like shape (95) or in an area between the two planes (E, E1).

14. An air passage device according to any one of claims 11 through 13,
**characterized in that,**
the cover device (100) consists of a frame-like housing (30) for accommodating the filter pad (60) and a design cover (80) which is held in the housing (30) firmly, detachably or in a manner allowing it to swivel and covers the filter pad (60) and which comprises at least two lateral supporting elements (81, 82) which are preferably flange-shaped and extend in a longitudinal direction (L) on the edge side and between which there are arranged multiple lamellar elements (90) which are arranged at a distance from one another and in such a way that, at the same time, they overlap in segments and are set obliquely such that the lamellar edges lying at the front and outwardly (91) in each case are set lower down than the rear lamellar edges (92), wherein the upper, rear lamellar edges (92) of those lamellar elements (90) which have a bow-shaped design have a barbed-hook-like shape. (95).

15. An air passage device according to any one of claims 11 through 14,
**characterized in that,**
the individual lamellar elements (90) are arranged with respect to one another in such a way that a high visual overlap and a visual cover for the filter pad (60) are maintained with optimal air transmissibility.

16. An air passage device according to any one of claims 11 through 15,
**characterized in that,**
the lamellar element which has an approximately S-shaped design (90) has a material filling (98) in its lower bow-shaped section and underneath that.

17. An air passage device according to any one of claims 11 through 16,
**characterized in that,**
the rear lamellar edge (92) which has the hook-like shape (95) of each lamellar element (90) has a cross-sectional shape which corresponds approximately to the shape of a semicircle with a segment (95a) protruding on the front side.

18. An air passage device according to any one of claims 11 through 17,
**characterized in that,**
the area of the front lamellar edge (91) of each lamellar element (90) has a material reinforcement (97), so that the lower-lying area of the front perimeter edge (91a) of each lamellar element has a greater thickness relative to the rear and higher-lying perimeter edge area (92a).

19. An air passage device according to any one of claims 11 through 18,
**characterized in that,**
the design cover (80) with its lamellar elements (90) consists of a plastic or another suitable material, wherein the lamellar elements are formed from one or multiple parts.

20. An air passage device according to any one of claims 11 through 19,
**characterized in that,**
each lamellar element (90) has rounded front longitudinal perimeter edges (96) to achieve a sound-optimized lamellar shape.

## Revendications

1. Dispositif de fermeture (100) pour fermer la zone avant d'un dispositif d'aération (200), comme un ventilateur filtrant ou un ventilateur de sortie, pour un montage dans une percée dans une paroi d'un boîtier, en particulier d'un boîtier ayant des composants produisant de la chaleur dissipée, d'une armoire électronique, d'une armoire de commande, d'un système de boîtier ou d'un système d'ordinateur, et pour la natte filtrante (60) du dispositif d'aération, le dispositif de fermeture comprenant un couvercle design (80) fermant la natte filtrante (60), avec un certain nombre d'éléments lamellaires (90) placés obliquement,
**caractérisé en ce que**
chaque élément lamellaire (90) présente dans sa zone supérieure (90a) un tronçon (90') orienté à l'opposé de l'arrivée du flux d'air et ayant une conformation (95) du type crochet.

2. Dispositif de fermeture selon la revendication 1,
**caractérisé en ce que**
le tronçon (90') ayant la conformation du type crochet (95) s'étend sur la longueur de l'élément lamellaire (90).

3. Dispositif de fermeture selon une des revendications 1 ou 2,
**caractérisé en ce que**
les éléments lamellaires (90) sont disposés les uns par rapport aux autres de sorte que les éléments lamellaires se chevauchent par tronçons, la zone inférieure (90b) de chaque élément lamellaire reposant sur un plan horizontal (E) disposé au-dessous du tronçon (90') ayant la conformation du type crochet (95), ou sur un plan (E1) horizontal disposé au-dessus du tronçon (90') ayant la conformation du type crochet (95), ou dans une zone entre les deux plans (E, E1).

4. Dispositif de fermeture selon une des revendications 1 à 3,
**caractérisé en ce que**
le dispositif de fermeture (100) se compose d'un boîtier (30) du type à cadre pour loger la natte filtrante (60) et d'un couvercle design (80), retenu dans le boîtier (30) de façon fixe, amovible ou pivotante et fermant la natte filtrante (60), qui comprend au moins deux éléments de retenue (81, 82) latéraux, s'étendant côté bord dans une direction longitudinale (L), constitués de préférence en forme de joue, et entre lesquels sont disposés plusieurs éléments lamellaires (90) qui sont disposés à distance les uns des autres tout en présentant un chevauchement par tronçons et sont placés obliquement de sorte que les arêtes lamellaires (91) respectivement avant et situées à l'extérieur sont placées plus bas par rapport aux arêtes lamellaires (92) arrière, les arêtes lamellaires (92) supérieures arrière des éléments lamellaires (90) présentant une configuration arquée présentant une conformation (95) constituée à la façon d'un ardillon.

5. Dispositif de fermeture selon une des revendications 1 à 4,
**caractérisé en ce que**
les différents éléments lamellaires (90) sont disposés les uns par rapport aux autres de sorte qu'un chevauchement optique élevé et une protection visuelle vers la natte filtrante (60) sont obtenus en même temps qu'une perméabilité à l'air optimale.

6. Dispositif de fermeture selon une des revendications 1 à 5,
**caractérisé en ce que**
l'élément lamellaire (90) présentant une configuration à peu près en forme de S présente un remplissage en matériau (98) dans sa zone inférieure arquée et au-dessous.

7. Dispositif de fermeture selon une des revendications 1 à 6,
**caractérisé en ce que**
l'arête lamellaire (92) arrière, présentant la conformation du type crochet (95), de chaque élément lamellaire (90) présente une forme de section transversale qui correspond à peu près à la forme d'un demi-cercle avec un tronçon (95a) débordant sur le côté avant.

8. Dispositif de fermeture selon une des revendications 1 à 7,
**caractérisé en ce que**
la zone de l'arête lamellaire (91) avant de chaque élément lamellaire (90) présente un renfort de matériau (97) de sorte que la zone d'arête de bord (91 a) avant placée plus bas de chaque élément lamellaire présente une épaisseur plus importante par rapport à la zone d'arête de bord (92a) arrière et placée plus haut.

9. Dispositif de fermeture selon une des revendications 1 à 8,
**caractérisé en ce que**
le couvercle design (80) avec ses éléments lamellaires (90) est composé d'une matière plastique ou d'un autre matériau approprié, les éléments lamellaires étant constitués d'une ou de plusieurs parties.

10. Dispositif de fermeture selon une des revendications 1 à 9
**caractérisé en ce que,**
pour obtenir une forme lamellaire optimisée en bruit, chaque élément lamellaire (90) présente des arêtes de bord longitudinales (96) avant arrondies.

11. Dispositif d'aération (200) comme un ventilateur filtrant ou un ventilateur de sortie, pour un montage dans une percée dans une paroi d'un boîtier, en particulier d'un boîtier ayant des composants produisant de la chaleur dissipée, d'une armoire électronique, d'une armoire de commande, d'un système de boîtier ou d'un système d'ordinateur, et pour la natte filtrante (60) du dispositif d'aération, qui comprend un dispositif de fermeture (100) pour fermer la zone avant, qui présente un couvercle design (80) fermant la natte filtrante (60) ayant un certain nombre d'éléments lamellaires (90) placés obliquement, chaque élément lamellaire (90) présentant dans sa zone supérieure (90a) un tronçon (90') orienté à l'opposé de l'arrivée du flux d'air et ayant une conformation (95) du type crochet.

12. Dispositif d'aération selon la revendication 11,
**caractérisé en ce que**
le tronçon (90') ayant la conformation (95) du type crochet s'étend sur la longueur de l'élément lamellaire (90).

13. Dispositif d'aération selon une des revendications 11 ou 12,
**caractérisé en ce que**
les éléments lamellaires (90) du dispositif de fermeture (100) sont disposés les uns par rapport aux autres de sorte que les éléments lamellaires se chevauchent par tronçons, la zone inférieure (90b) de chaque élément lamellaire reposant sur un plan (E) horizontal disposé au-dessous du tronçon (90') ayant la conformation du type crochet (95), ou sur un plan (E1) horizontal disposé au-dessus du tronçon (90') ayant la conformation du type crochet (95), ou dans une zone entre les deux plans (E, E1).

14. Dispositif d'aération selon une des revendications 11 à 13,
**caractérisé en ce que**
le dispositif de fermeture (100) se compose d'un boîtier (30) du type à cadre pour loger la natte filtrante (60) et d'un couvercle design (80), retenu dans le boîtier (30) de façon fixe, amovible ou pivotante et fermant la natte filtrante (60), qui comprend au moins deux éléments de retenue (81, 82) latéraux, s'étendant côté bord dans une direction longitudinale (L), constitués de préférence en forme de joue, et entre lesquels sont disposés plusieurs éléments lamellaires (90) qui sont disposés à distance les uns des autres tout en présentant un chevauchement par tronçons et sont placés obliquement de sorte que les arêtes lamellaires (91) respectivement avant et situées à l'extérieur sont placées plus bas par rapport aux arêtes lamellaires (92) arrière, les arêtes lamellaires (92) supérieures arrière des éléments lamellaires (90) présentant une configuration arquée présentant une conformation (95) constituée à la façon d'un ardillon.

15. Dispositif d'aération selon une des revendications 11 à 14,
**caractérisé en ce que**
les différents éléments lamellaires (90) sont disposés les uns par rapport aux autres de sorte qu'un chevauchement optique élevé et une protection visuelle vers la natte filtrante (60) sont obtenus en même temps qu'une perméabilité à l'air optimale.

16. Dispositif d'aération selon une des revendications 11 à 15,
**caractérisé en ce que**
l'élément lamellaire (90) présentant une configuration à peu près en forme de S présente un remplissage en matériau (98) dans sa zone inférieure arquée et au-dessous.

17. Dispositif d'aération selon une des revendications 11 à 16,
**caractérisé en ce que**
l'arête lamellaire (92) arrière, présentant la conformation du type crochet (95), de chaque élément lamellaire (90) présente une forme de section transversale qui correspond à peu près à la forme d'un demi-cercle avec un tronçon (95a) débordant sur le côté avant.

18. Dispositif d'aération selon une des revendications 11 à 17,
**caractérisé en ce que**
la zone de l'arête lamellaire (91) avant de chaque élément lamellaire (90) présente un renfort de matériau (97) de sorte que la zone d'arête de bord (91 a) avant placée plus bas de chaque élément lamellaire présente une épaisseur plus importante par rapport à la zone d'arête de bord (92a) arrière et placée plus haut.

19. Dispositif d'aération selon une des revendications 11 à 18,
**caractérisé en ce que**
le couvercle design (80) avec ses éléments lamellaires (90) est composé d'une matière plastique ou d'un autre matériau approprié, les éléments lamellaires étant constitués d'une ou de plusieurs parties.

20. Dispositif d'aération selon une des revendications 11 à 19,
**caractérisé en ce que,**
pour obtenir une forme lamellaire optimisée en bruit, chaque élément lamellaire (90) présente des arêtes de bord longitudinales (96) avant arrondies.
